# EUROPEAN PATENT APPLICATION

(11) **EP 1 630 604 A2**
(43) Date of publication of application: **01.03.2006**
(21) Application number: 05018603.0
(22) Date of filing: 26.08.2005
(51) Int. Cl.: G03F 7/031

(54) **Photosensitive lithographic printing plate**

(30) Priority: 27.08.2004 JP 2004248621
(71) Applicant: FUJI PHOTO FILM CO., LTD., Minami-Ashigara-shi, Kanagawa-ken (JP)
(72) Inventor: Sakata, Kaku, Fuji Photo Film Co., Ltd, Haibara-gun Shizuka (JP)
(74) Representative: HOFFMANN EITLE

(57) **Abstract**

A photosensitive lithographic printing plate to be exposed by laser, which comprises a hydrophilic support and at least one polymerizable photosensitive layer, wherein the photosensitive layer has an absorbance of an emitting wavelength of the laser for exposure of not more than 0.4.

## Description

### FIELD OF THE INVENTION

The present invention relates to a photosensitive lithographic printing plate. In particular, the invention relates to a photosensitive printing plate which is suitable for image drawing by laser light and which is suitable for high definition AM screen printing with the number of screen lines of 200 lines or more or FM screen printing.

### BACKGROUND OF THE INVENTION

Hitherto, a desired printing plate was obtained by using a lithographic printing plate having a construction comprising a support having a hydrophilic surface and having a photosensitive resin layer provided thereon and by usually employing a plate-making method by subjecting the lithographic printing plate to surface exposure (mask exposure) via a lith film and then removing a non-image area by a developing solution. However, in accordance with a recent digitalizing technology, a computer-to-plate (CTP) technology for performing exposure directly on a plate surface without using a lith film by scanning light with high directivity such as laser light according to digitalized image information has been developed, and photosensitive lithographic printing plates adaptive thereto have also been developed.

As such a photosensitive printing plate which is suitable for exposure with laser light, there can be enumerated a photosensitive lithographic printing plate using a polymerizable photosensitive layer. This is because the polymerizable photosensitive layer makes it easy to realize high sensitivity by choosing a polymerization initiator or polymerization initiation system (hereinafter sometimes referred to simply as "initiator" or "initiation system") as compared with other conventional photosensitive layers.

However, in the foregoing photosensitive lithographic printing plate, since image drawing is performed by using laser light, an edge portion of the image depends upon the shape of energy distribution of laser light so that a region where the polymerization is insufficient is formed following a shortage of the amount of exposure. For that reason, sharpness of the image edge portion was impaired, resulting in a reduction of the resolution. Furthermore, such an image edge portion where the polymerization is insufficient caused inferior removal depending upon the alkaline concentration of the developing solution in the development treatment step or the state of a development brush so that in-plane scattering of a halftone dot area of the prepared printing plate became large.

In addition, in such a printing plate, in order to secure hydrophilicity, a support in which irregularities are formed on the surface by electrolytic treatment, brush treatment, etc. is used. Accordingly, the image quality and sharpness are further impaired due to scattering of reflected light at the time of laser exposure, resulting in a large reduction of reproducibility of a shadow portion.

On the other hand, in recent years, in the foregoing CTP technology, the requirements of high definition AM screen printing or FM screen printing are heightened, and the resolution of a lithographic printing plate has become an important performance.

The FM (frequency modulation) screen as referred to herein is one in which fine halftone dots of approximately 20 microns are aligned at random regardless of a screen angle or the number of screen lines and a density gradation is expressed by a density of halftone dots per unit area. Printed matters by this FM screen printing are characterized in that an interference moiré or Rosseta pattern is not generated; that tone jump is not generated in a half tone portion in the vicinity of 50 %; and that since the halftone dots are small, halftone dots scarcely overlap each other so that reproduced colors are vividly seen.

Contrary to the FM screen, the AM (amplitude modulation) screen is meant by one in which halftone dots are regularly aligned at a certain angle and the density gradation is expressed by the size of halftone dots per unit area. In Japan, the number of screen lines of the AM screen is 175 lines per inch. Contrary to this, in general, the high definition screen is meant by one using the number of screen lines of 200 lines or more.

High definition printed matters are characterized by a reduction of a moiré or Rosseta pattern, an enhancement of a texture of the image, and enhancements of a sense of reality and reproducibility of fine portions.

However, according to a photosensitive material with reduced reproducibility of a shadow portion, such as lithographic printing plates using a polymerizable photosensitive layer as described previously, for the purpose of providing a printing plate suitable for FM screen or high definition AM screen, it was difficultly used because it cannot reproduce extremely fine halftone dots.

Furthermore, JP-A-2003-43703 discloses a photosensitive lithographic printing plate comprising a support having thereon an interlayer containing a high-molecular compound having a constituent unit having a sulfonic group in the side chain thereof and a polymerizable photosensitive layer in this order. However, this photosensitive lithographic printing plate is not sufficient yet as a plate material suitable for high definition AM screen or FM screen printing. In particular, unevenness in flat tint is vigorous in the FM screen so that it was difficult to use the FM screen.

### SUMMARY OF THE INVENTION

An object of the invention is to provide a photopolymerization type photosensitive lithographic printing plate which is suitable for image drawing by laser light and which has good uniformity of unevenness in flat tint of a half tone by high definition AM screen printing with the number of screen lines of 200 lines or more or FM screen printing, especially FM screen printing.

The present inventors made extensive and intensive investigations. As a result, it has been found that in a circumstance where sensitivity and high definition are in the trade-off relation, by blending a sensitizing dye such that an OD value of the photosensitive layer in the exposure wavelength becomes small, it is possible to make the both sensitivity and high definition compatible with each other, leading to accomplishment of the invention.

That is, the invention is as follows.
(1) A photosensitive lithographic printing plate to be exposed by laser, which comprises a hydrophilic support having thereon at least one polymerizable photosensitive layer, wherein the photosensitive layer has an absorbance (Abs) of an emitting wavelength of the laser for exposure of not more than 0.4.
(2) The photosensitive lithographic printing plate as set forth above in (1), wherein the amount of coating of the photosensitive layer is from 0.5 g/m² to 3.0 g/m².
(3) The photosensitive lithographic printing plate as set forth above in (1) or (2), wherein the photosensitive layer is one containing the following components of (A) a sensitizing dye having an absorption maximum in a wavelength region of from 360 nm to 450 nm, (B) a polymerization initiator, (C) an ethylenically unsaturated double bond-containing addition polymerizable compound, and (D) a binder polymer, with a weight ratio of the component (C) to the component (D) being not more than 1.5.

According to the invention, there is provided a photopolymerization type photosensitive lithographic printing plate which is suitable for image drawing by laser light and which has good uniformity of unevenness in flat tint of a half tone by high definition AM screen printing with the number of screen lines of 200 lines or more or FM screen printing, especially FM screen printing.

### DETAILED DESCRIPTION OF THE INVENTION

### [Photosensitive lithographic printing plate]

With respect to a photosensitive lithographic printing plate (lithographic printing plate precursor) having spectral sensitivity in a wavelength region of from 360 nm to 450 nm, which is used in the invention, its construction will be successively described below.

### [Support]

First of all, a support of the photosensitive lithographic printing plate which is used in the invention will be described.

As the support which can be used in the invention, though any material is useful so far as its surface is hydrophilic, a dimensionally stable plate-like material is preferable. Examples thereof include papers, papers laminated with a plastic (for example, polyethylene, polypropylene, and polystyrene), plates of a metal (for example, aluminum (inclusive of aluminum alloys) , zinc, and copper) or an alloy thereof (for example, alloys with silicon, copper, manganese, magnesium, chromium, zinc, lead, bismuth, nickel, etc.), films of a plastic (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, and polyvinyl acetate) , and papers or plastic films laminated or vapor deposited with the foregoing metal or metal alloy. Of these supports, aluminum plates are especially preferable because they are remarkably dimensionally stable and cheap. In addition, a composite sheet in which an aluminum sheet is bound on a polyethylene terephthalate film as described in JP-B-48-18327 is also preferable. Usually, its thickness is from approximately 0.05 mm to 1 mm .

Furthermore, in particular, in the case of a support having a surface of aluminum, it is preferable that the support is subjected to surface treatment such as graining treatment, dip treatment in an aqueous solution of sodium silicate, potassium fluorozirconate, a phosphate, etc., and anodic oxidation treatment as described later.

### [Graining treatment]

Examples of the graining treatment include mechanical graining, chemical etching, and electrolytic graining as disclosed in JP-A-56-28893. In addition, an electrochemical graining method for performing electrochemical graining in a hydrochloric acid or nitric acid electrolytic liquid and a mechanical graining method such as a wire brush graining method for scratching the aluminum surface by a metallic wire, a ball graining method for graining the aluminum surface by an abrasive ball and an abrasive material, and a brush graining method for graining the surface by a nylon brush and an abrasive material are employable. The foregoing graining methods can be carried out singly or in combination.

Above all, a method for preparing a surface roughness to be usefully employed in the invention is an electrochemical method for performing chemical graining in a hydrochloric acid or nitric acid electrolytic liquid, and a suitable current density is in the range of from 100 C/dm² to 400 C/dm². More specifically, it is preferable that the electrolysis is carried out in an electrolytic liquid containing from 0.1 to 50 % of hydrochloric acid or nitric acid under conditions at a temperature of from 20 to 100 °C for a period of time of from 1 second to 30 minutes and at a current density of from 100 C/dm² to 400 C/dm².

The thus grained aluminum support is chemically etched with an acid or alkali. In the case of using an acid as an etchant, since it takes a long period of time for breaking a fine structure, such is disadvantageous for industrially applying the invention. However, by using an alkali as an etchant, this disadvantage can be improved.

Examples of the alkaline agent which can be suitably used in the invention include sodium hydroxide, sodium carbonate, sodium aluminate, sodium metasilicate, sodium phosphate, potassium hydroxide, and lithium hydroxide. Preferred ranges of the concentration and temperature are from 1 to 50 % and from 20 to 100 °C, respectively. The amount of dissolution of aluminum is preferably from 5 to 20 g/m³.

After the etching, for the purpose of removing smuts remaining on the surface, acid washing is carried out. Examples of the acid to be used include nitric acid, sulfuric acid, phosphoric acid, chromic acid, hydrofluoric acid, and borofluoric acid. In particular, as the method for removing smuts after the electrochemical roughing treatment, a method for bringing it into contact with sulfuric acid of from 15 to 65 % by weight at a temperature of from 50 to 90 °C as described in JP-A-53-12739 and an alkaline etching method as described in JP-B-48-28123 are preferable.

Incidentally, in the invention, a preferred surface roughness (Ra) of the aluminum support is from 0.3 to 0.7 µm.

### [Anodic oxidation treatment]

The thus treated aluminum support is further subjected to anodic oxidation treatment.

The anodic oxidation treatment can be carried out by a method which has hitherto been employed in this technical field.

Specifically, it is possible to form an anodically oxidized film on the surface of the aluminum support by passing a direct current or alternating current through aluminum in an aqueous solution or non-aqueous solution of sulfuric acid, phosphoric acid, chromic acid, oxalic acid, sulfamic acid, benzenesulfonic acid, etc. or a combination of two or more kinds thereof.

The conditions of the anodic oxidation treatment vary in all sorts of ways depending upon an electrolytic liquid to be used and therefore, cannot be unequivocally determined. However, in general, it is suitable that the concentration of the electrolytic liquid ranges from 1 to 80 %; the liquid temperature ranges from 5 to 70 °C; the current density ranges from 0.5 to 60 A/dm²; the voltage ranges from 1 to 100 V; and the electrolysis time ranges from 10 to 100 seconds.

Among these anodic oxidation treatments, a method for performing anodic oxidation in sulfuric acid at a high current density as described in U.K. Patent No. 1,412,768 and a method for performing anodic oxidation using phosphoric acid as an electrolytic bath as described in U.S. Patent No. 3,511,661 are especially preferable.

In the invention, the anodically oxidized film is preferably from 1 to 10 g/m², more preferably from 1.5 to 7 g/m², and further preferably from 2 to 5 g/m².

In addition, in the invention, the support may be subjected to sealing treatment after the graining treatment and anodic oxidation treatment. The sealing treatment is carried out by dipping the substrate in a hot aqueous solution containing hot water and an inorganic salt or organic salt, a steam bath, or the like. Furthermore, the support which is used in the invention may be subjected to surface treatment other than silicate treatment with an alkali metal silicate, such as dipping treatment in an aqueous solution of potassium fluorozirconate, a phosphate, etc.

In the invention, a photosensitive lithographic printing plate is formed by, for example, applying a polymerizable photosensitive layer composed of a photosensitive composition on the support (in the case of aluminum, aluminum having been subjected to appropriate surface treatment as described previously is preferable) and subsequently applying a protective layer. In this case, if desired, an organic or inorganic undercoat layer may be provided prior to the application of a polymerizable photosensitive layer, or the support may be subjected to sol-gel treatment having a functional group capable of causing addition reaction by a radical covalent bonded thereto as disclosed in JP-A-7-159983.

Examples of a substance which forms the organic undercoat layer include water-soluble resins (for example, polyvinylphosphonic acid, polymers or copolymers having a sulfonic group in the side chain thereof, and polyacrylic acid) , water-soluble metal salts (for example, zinc borate), yellow dyes, and amine salts.

More specifically, examples of an organic compound which is used in the organic undercoat layer include carboxymethyl cellulose, dextrin, gum arabic, amino group-containing phosphonic acids (for example, 2-aminoethylphosphonic acid), organic phosphonic acids (for example, phenylphosphonic acid, naphthylphosphonic acid, alkylphosphonic acids, glycerophosphonic acid, methylenediphosphonic acid, and ethylenediphosphonic acid, each of which may have a substituent), organic phosphoric acids (for example, phenylphosphoric acid, naphthylphosphoric acid, alkylphosphoric acids, and glycerophosphoric acid, each of which may have a substituent), organic phosphinic acids (for example, phenylphosphinic acid, naphthylphosphinic acid, alkylphosphinic acids, and glycerophosphinic acid, each of which may have a substituent), amino acids (for example, glycine and β-alanine) , and hydroxyl group-containing amine hydrochlorides (for example, triethanolamine hydrochloride) . These organic compounds may be used in admixture of two or more kinds thereof.

This organic undercoat layer can be provided by the following method. That is, examples of the method include a method in which a solution having the foregoing organic compound dissolved in water or an organic solvent (for example, methanol, ethanol, and methyl ethyl ketone) or a mixed solvent thereof is coated on a support and then dried to provide an organic undercoat layer; and a method in which a support is dipped in a solution having the foregoing organic compound dissolved in water or an organic solvent (for example, methanol, ethanol, and methyl ethyl ketone) or a mixed solvent thereof to adsorb the foregoing organic compound thereon and then washed with water, etc. and dried to provide an organic undercoat layer. In the former method, a solution of the foregoing organic compound having a concentration of from 0.005 to 10 % by weight can be coated by a variety of methods. For example, any of methods including bar coater coating, rotary coating, spray coating, and curtain coating may be employed. Furthermore, in the latter method, the concentration of the solution is from 0.01 to 20 % by weight, and preferably from 0.05 to 5 % by weight; the dipping temperature is from 20 to 90 °C, and preferably from 25 to 50 °C**;** and the dipping time is from 0.1 seconds to 20 minutes, and preferably from 2 seconds to one minute.

The solution which is used therefor is adjusted as to adjust the pH with a basic substance (for example, ammonia, triethylamine, and potassium hydroxide) or an acidic substance (for example, hydrochloric acid and phosphoric acid) , whereby it can be used at a pH in the range of from 1 to 12. For the purpose of improving tone reproducibility of the photopolymerization type photosensitive lithographic printing plate, a yellow dye can also be added.

The amount of coating of the organic undercoat layer after drying is suitably from 2 to 200 mg/m², and preferably from 5 to 100 mg/m². Within the foregoing range, sufficient printing resistance is obtained.

Furthermore, examples of a substance which is used in the inorganic undercoat layer include inorganic salts (for example, cobalt acetate, nickel acetate, and potassium fluorotitanate) . A method for providing this inorganic undercoat layer is the same as in the foregoing organic undercoat layer.

### [Photosensitive layer]

The photosensitive layer of the photosensitive lithographic printing plate which is used in the invention has at least spectral sensitivity in a wavelength region of from 360 nm to 450 nm. The photosensitive layer is preferably constructed so as to contain the following components (A) to (D):
(A) a sensitizing dye having an absorption maximum in a wavelength region of from 360 nm to 450 nm,
(B) a polymerization initiator, and preferably a titanocene compound,
(C) an ethylenically unsaturated double bond-containing addition polymerizable compound, and
(D) a binder polymer.

These will be successively described below.

### [(A) Sensitizing dye]

The sensitizing dye which is used in the photosensitive lithographic printing plate to be used in the invention is a sensitizing dye having an absorption maximum in a wavelength region of from 360 nm to 450 nm. Examples of such a sensitizing dye include merocyanine dyes represented by the following formula (2), benzopyrans or coumarins represented by the following formula (3), aromatic ketones represented by the following formula (4), and anthracenes represented by the following formula (5).

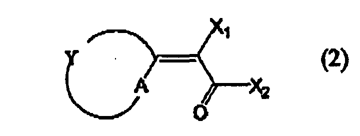

In the foregoing formula (2) , A represents an S atom or NR₆; R₆ represents a monovalent non-metallic atomic group; Y represents a non-metallic atomic group for forming a basic nucleus of dye jointly with the adjacent A and adjacent carbon atom; X₁ and X₂ each independently represents a monovalent non-metallic atomic group; and X₁ and X₂ may be taken together to form an acidic nucleus of dye.

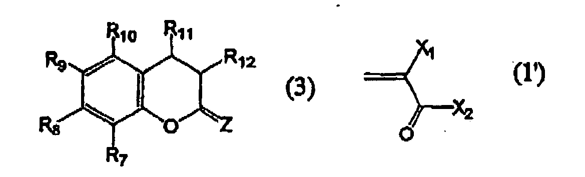

In the foregoing formula (3), =Z represents a carbonyl group, a thiocarbonyl group, an imino group, or an alkylidene group represented by the foregoing partial structural formula (1') ; X₁ and X₂ are synonymous with those in the formula (2) ; and R₇ to R₁₂ each independently represents a monovalent non-metallic atomic group.

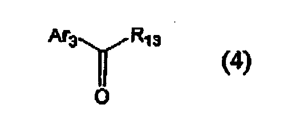

In the foregoing formula (4), Ar₃ represents an optionally substituted aromatic group or heteroaromatic group; and R₁₃ represents a monovalent non-metallic atomic group. More preferably, R₁₃ is an aromatic group or a heteroaromatic group; and Ar₃ and R₁₃ may be taken together to form a ring.

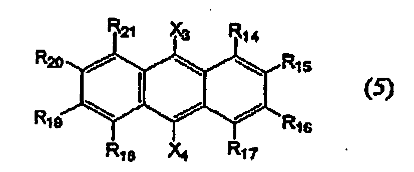

In the foregoing formula (5) , X₃, X₄, and R₁₄ to R₂₁ each independently represents a monovalent non-metallic atomic group. More preferably, X₃ and X₄ are each an electron-donating group having a negative Hammett's substituent constant.

Preferred examples of the monovalent non-metallic atomic group represented by X₁ to X₄ and R₆ to R₂₁ in the formulae (2) to (5) include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eicosyl group, an isopropyl group, an isobutyl group, an s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbonyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylatainopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl) carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group., a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, α-methylbenzyl group, a 1-methyl-l-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propenyl group, a 2-butynyl group, and a 3-butynyl group) , an aryl group (for example, a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a phenyl group, a cyanophenyl group, a sulfophenyl group, a sulfonatophenyl group, a phosphonophenyl group, and a phosphonatophenyl group), a heteroaryl group (for example, thiophene, thianthrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthylidine, quinazoline, cinoline, pteridine, carbazole, carboline, phenanthrene, acridine, perimidine, phenanthroline, phthalazine, phenarsazine, phenoxazine, furazane, and phenoxazine), an alkenyl group (for example, a vinyl group, a 1-propenyl group, a 1-butenyl group, a cinnamyl group, and a 2-chloro-l-ethenyl group), an alkynyl group (for example, an ethynyl group, a 1-propynyl group, a 1-butynyl group, and a trimethylsilylethynyl group), a halogen atom (for example, -F, -Br, -Cl, and -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbbamoyloxy group, an alkylsulfoxy group, an arylsulfoxy group, an acylthio group, an acylamino group, an N-alkylacylamino group, an N-arylactylamino group, an ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-al - kyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycabonylamino group, an aryl-N-alkoxycarbonyl-amino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as "sulfanato group"), an alkoxy-sulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as "alkylphosphonato group"), a monoarylphosphono group (-PO₃H (aryl)) and its conjugated base group (hereinafter referred to as "arylphosphonato group"), a phosphonoxy group (-OPO₃H₂) and its conjugated base group (hereinafter referred to as "phosphonatooxy group"), a dialkylphosphonoxy group (-OPO₃(alkyl)₂) , a diarylphosphonoxy group (-OPO₃(aryl)₂) , an alkylarylphosphonoxy group (-OPO₃(alkyl) (aryl)), a monoalkylphosphonoxy group (-OPO₃H(alkyl)) and its conjugated base group (hereinafter referred to as '"alkylphosphonatooxy group"), a monoarylphosphonoxy group (-OPO₃H(aryl)) and its conjugated base group (hereinafter referred to as "axylphosphonatooxy group") , a cyano group, and a nitro group. Of these groups, a hydrogen atom, an alkyl group, an aryl group, a halogen atom, an alkoxy group, and an acyl group are especially preferable.

Examples of the basic nucleus of dye which Y forms jointly with the adjacent A and adjacent carbon atom in the formula (2) include 5-, 6- or 7-membered nitrogen-containing or sulfur-containing rings. Of these, 5- or 6-membered hetero rings are preferable.

As the nitrogen-containing hetero ring, any of rings which are known to constitute a basic nucleus in merocyanine dyes as described in, for example, L.G. Brooker, et al., J. *Am*. *Chem. Soc.,* 73, 5326-5358 (1951) and references as cited therein can be suitably used.

Specific examples thereof include, thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenylthiazole), and 4-(2-thienyl) thiazole), benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothzazole, 5-bromobenzothiazole, 4-phenylbenzothiazole, 5-phenylbenzothiazole, 4-methoxybenzothiazole, 5-methoxybenzothaizole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydxoxybenzothiazole, 6-dimethylaminobenzothiazole, and 5-ethoxycarbonylbenzothiazole), naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole, and 7-methoxynaphtho-[1,2]thiazole), thianaphtheno-7',6',4,5-thiazoles (for example, 4'-methoxythianaphtheno-7',6',4,5-thiazole), oxazoles (for example, 4-methyloxazole, 5-methyloxazole, 4-phenyloxazole, 4,5-diphenyloxazole, 4-ethyloxazole, 4,5-dimethyloxazole, and 5-phenyloxazole) , benzoxazoles (for example, benzoxazole, 5-chlorobenzoxole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole, and 6-hydroxybenzoxazole), naphthoxazoles (for example, naphth[1,2]oxazole and naphth[2,1]oxazole), selenazoles (for example, 4-methylselenazole and 4-phenylselenazole) , benzoselenazoles (for example, benzoselenazole, 5-chlorobenzoselenazole, 5-methoxybenzoselenazole, 5-hydroxybenzoselenazole, and tetrahydroxybenzoselenazole), naphthoselenazoles (for example, naphtho [1,2] selenazole and naphtho[2,1]selenazole), thiazolines (for example, thiazoline and 4-methylthiazoline), 2-quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline, and 8-hydroxyquinoline), 4-quinolines (for example, quinoline, 6-methoxyquinoline, 7-methylquinoline, and 8-methylquinoline), 1-isoquinolines (for example, isoquinoline and 3,4-dihydroisoquinoline), 3-isoquinolines (for example, isoguinoline), benzimidazoles (for example, 1,3-diethylbenzimidazole and 1 -ethyl -3-phenylbenzimidazole) 3,3-dialkylindolenines (for example, 3,3-dimethylindolenine, 3,3,5-trimethylindolenine, and 3,3,7-trimethylindolenine), 2-pyridines (for example, pyridine and 5-methylpyridine) , and 4-pyridines (for example, pyridine).

Furthermore, examples of the sulfur-containing hetero ring include dithiol partial structures in dyes as described in JP-A-3-296759.

Specific examples thereof include benzodithiols (for example, benzodithiol, 5-t-butylbenzodithiol, and 5-methylbenzodithiol) , naphthodithiols (for example, naphtho-[1,2]dithiol and naphtho[2,1]dithiol), and dithiols (for example, 4,5-dimethyldithiols, 4-phenyldithiols, 4-methoxycarbonyldithiols, 4,5-dimethoxycarbonylbenzodithiols, 4,5-ditrifluoromethyldithiol, 4,5-dicyanodithiol, 4-methoxycarbonylmethyldithiol, and 4-carboxymethyldithiol) .

In the description as used for the explanation regarding the foregoing hetero rings, the nomenclatures of hetero ring mother skeletons have been conventionally used for convenience. When the hetero ring constitutes a basic skeleton partial structure of sensitizing dye, for example, in the case of a benzothiazole skeleton, it is introduced in the form of an alkylidene type substituent in which a degree of unsaturation is decreased by one, as in a 3-substituted-2 (3H) -benzothiazolylidene group.

Among the sensitizing dyes having an absorption maximum in a wavelength region of from 360 nm to 450 nm, a dye represented by the following formula (1) is more preferable from the viewpoint of high sensitivity.

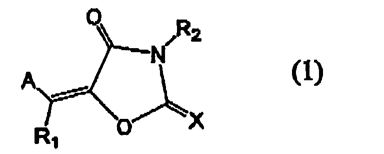

In the foregoing formula (1), A represents an optionally substituted aromatic ring or hetero ring; X represents an oxygen atom, a sulfur atom, or N-(R₃); R₁, R₂, and R₃ each independently represents a hydrogen atom or a monovalent non-metallic atomic group; and A and R₁, or R₂ and R₃ may be bound to each other for forming an aliphatic or aromatic ring.

The formula (1) will be hereunder described in more detail. R₁,R₂, and R₃ each independently represents a hydrogen atom or a monovalent non-metallic atomic group, and preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxyl group, a halogen atom, or a carboxyl group.

More preferred examples of R₁, R₂, and R₃ will be specifically described below. Preferred examples of the alkyl group include linear, branched or cyclic alkyl groups having from 1 to 20 carbon atoms. Specific examples thereof include a methyl group, an ethyl group, a propyl group, a butyl group, a pentyl group, a hexyl group, a heptyl groups an octyl group, a nonyl group, a decyl group, an undecyl group, a dodecyl group, a tridecyl group, a hexadecyl group, an octadecyl group, an eicosyl group, an isopropyl group, an isobutyl group, a sec-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group. Of these, linear alkyl groups having from 1 to 12 carbon atoms, branched alkyl groups having from 3 to 12 carbon atoms, and cyclic alkyl groups having from 5 to 10 carbon atoms are more preferable.

As the substituent of the substituted alkyl group, a monovalent non-metallic atomic group other than hydrogen is used. Preferred examples thereof include a halogen atom (for example, -F, -Br, -Cl, and -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diaryl-carbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, an ureido group, an N'-alkylureido group, an N' ,N' -dialkylureido group, an N' -arylureido group, an N' ,N' -diarylureido group, an N' -alkyl-N' -arylureido group, an N-alkylureido group, an N-arylureido group, an N' -alkyl-N-alkylureido group, an N'-alkyl-N-arylureido group, an N' ,N' -dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an. N'-alkyl-N'-aryl-N-arylureido group, an alkoxycarbonylamino group, an aryloxycarbonylamino group, an N-alkyl-N-alkoxycarbonylamino group, an N-alkyl-N-aryloxycabonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as "sulfonato group") , an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as "phosphonato group"), a dialkylphosphono group (-PO₃(alkyl)₂) , a diarylphosphono group (-PO₃(aryl)₂), an alkylarylphosphono group (-PO₃ (alkyl) (aryl)), a monoalkylphosphono group (-PO₃H(alkyl)) and its conjugated base group (hereinafter referred to as "alkylphosphonato group"), a monoarylphosphono group (-PO₃H(aryl)) and its conjugated based group (hereinafter referred to as "arylphosphonato group"), a phosphonoxy group (-OPO₃H₂) and its conjugated base group (hereinafter referred to as "phosphonatooxy group") , a dialkylphosphonoxy group (-OPO₃(alkyl)₂), a diarylphosphonoxy group (-OPO₃₋(aryl)₂) , an alkylarylphosphonoxy group (-OPO₃ (alkyl) (aryl)) , a monoalkylphosphonoxy group (-OPO₃H(alkyl)) and its conjugated base group (hereinafter referred to as "alkylphosphonatooxy group"), a monoarylphosphorloxy group (-OPO₃H (aryl)) and its conjugated base group (hereinafter referred to as "arylphosphonatooxy group"), a cyano group, a nitro group, an aryl group, a heteroaryl group, an alkenyl group, and an alkynyl group.

In these substituents, specific examples of the alkyl group include the foregoing alkyl groups; and specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a phenyl group, a cyanophenyl group, a sulfophenyl group, a sulfonatophenyl group, a phosphonophenyl group, and a phosphonatophenyl group.

As the preferred heteroaryl group as R₁, R₂, and R₃, a monocyclic or polycyclic aromatic ring containing at least one of nitrogen, oxygen and sulfur atoms is used. As the especially preferred heteroaryl group, there are enumerated thiophene, thianthrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthylidine, quinazoline, cinoline, pteridine, carbazole, carboline, phenanthrene, acridine, perimidine, phenanthroline, phthalazine, phenarsazine, phenoxazine, furazane, and phenoxazine. These may be further benzo-fused or may have a substituent.

Furthermore, preferred examples of the alkenyl group as R₁, R₂ , and R₃ include a vinyl group, a 1-propenyl group, a 1-butenyl group, a cinnamyl group, and a 2-chloro-l-ethenyl group; and examples of the alkynyl group include an ethynyl group, a 1-propynyl group, a 1-butynyl group, and a trimethylsilylethynyl group. As G1 in the acyl group (G1CO-) , hydrogen and the foregoing alkyl group and aryl group can be enumerated. Of these substituents, a halogen atom (for example, -F, -Br, -Cl, and -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonoxy group, a phosphonatooxy group, an aryl group, and an alkenyl group are further preferable.

On the other hand, as the alkylene group on the substituted alkyl group, there are enumerated divalent organic residues resulting from elimination of any one of hydrogen atoms on the foregoing alkyl group having from 1 to 20 carbon atoms. Of these, linear alkylene groups having from 1 to 12 carbon atoms, branched alkylene groups having from 3 to 12 carbon atoms, and cyclic alkylene groups having from 5 to 10 carbon atoms are preferable.

Specific examples of the preferred substituted alkyl group as R₁, R₂, and R₃ as obtained by combining the subject substituent with the alkylene group include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonoxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, and a 3-butynyl group.

Specific examples of the aryl group which is preferred as R₁, R₂, and R₃ include ones resulting from the formation of a fused ring of from one to three benzene rings and ones resulting from the formation of a fused ring of a benzene ring and a 5-membered unsaturated ring. Specific examples thereof include a phenyl group, a naphthyl group, an anthryl group, a phenanthryl group, an indenyl group, an acenaphthenyl group, and a fluorenyl group. Of these, a phenyl group and a naphthyl group are more preferable.

Specific examples of the substituted aryl group which is preferred as R₁, R₂, and R₃ include ones having a monovalent non-metallic atomic group other than hydrogen as the substituent on the ring-forming carbon atoms of the foregoing aryl group. Examples of the preferred substituent include the foregoing alkyl groups and substituted alkyl groups and those as enumerated as the substituent in the foregoing substituted alkyl group. Preferred examples of such substituted aryl groups include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylalninophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfarnoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allyl group, a 1-propenylmethyl group, a 2-butenyl group, a 2-methylallylphenyl group, a 2-methylpropenylphenyl group, a 2-propynylphenyl group, a 2-butynylphenyl group, and a 3-butynylphenyl group.

Next, A in the formula (1) will be described below. A represents an optionally substituted aromatic ring or hetero ring. As specific examples of the optionally substituted aromatic ring or hetero ring, those which are the same described above for R₁, R₂, and R₃ in the formula (1) are enumerated.

The sensitizing dye represented by the formula (1) according to the invention is obtained by condensation reaction between the foregoing acidic nucleus or active methylene group-containing acidic nucleus and a substituted or unsubstituted aromatic ring or hetero ring and can be synthesized while referring to JP-B-59-28329.

Specific examples (D1) to (D38) which are preferable as the compound represented by the formula (1) will be given below. Furthermore, with respect to isomers by a double bond for bonding an acidic nucleus to a basic nucleus, it should be construed that the invention is not limited to any isomer.

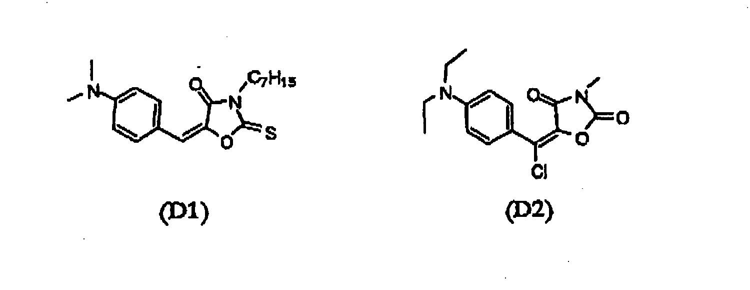

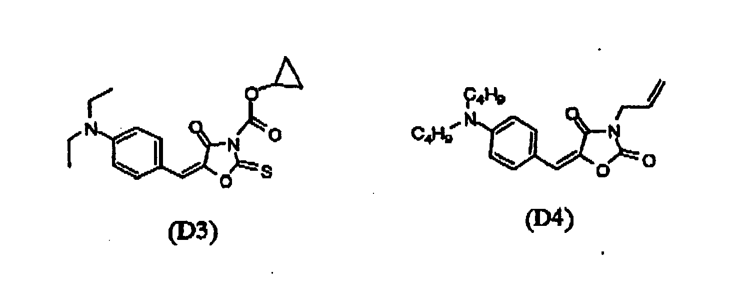

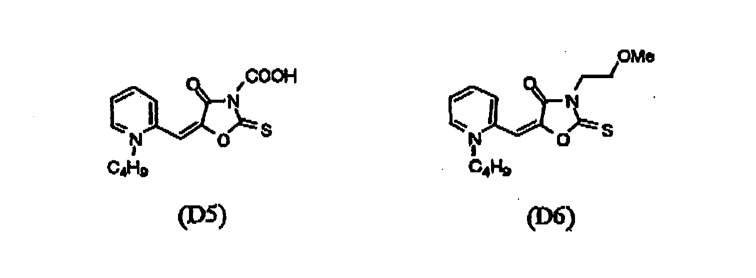

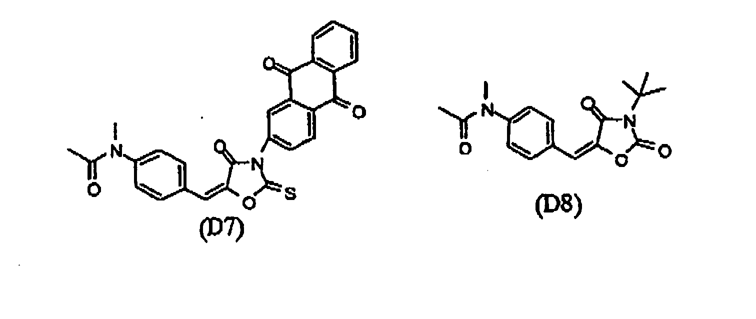

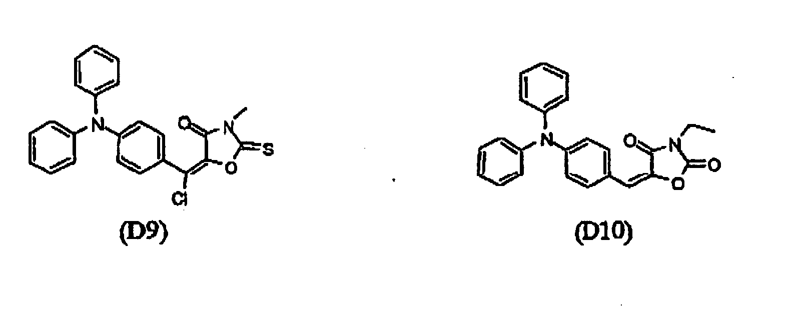

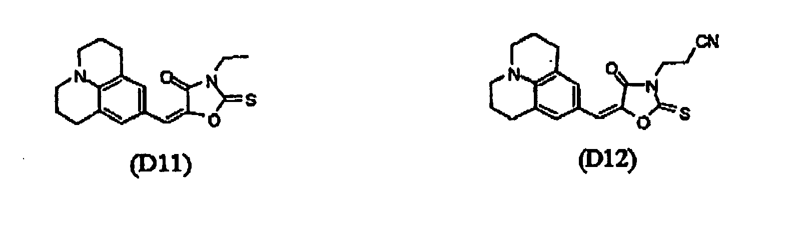

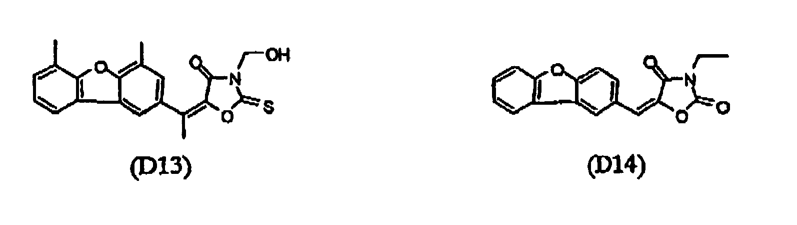

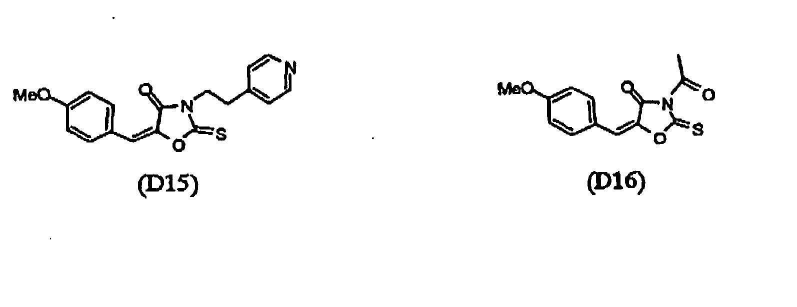

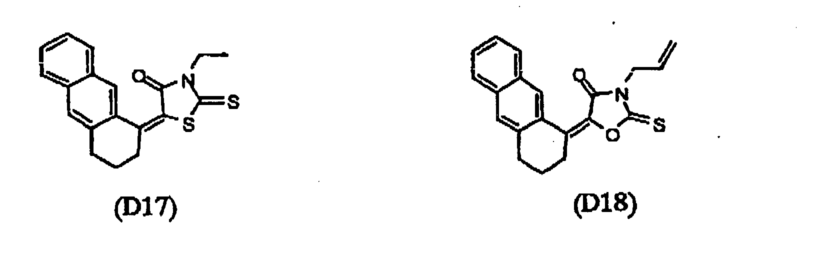

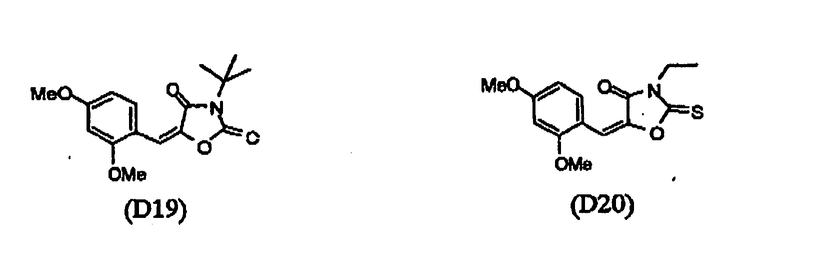

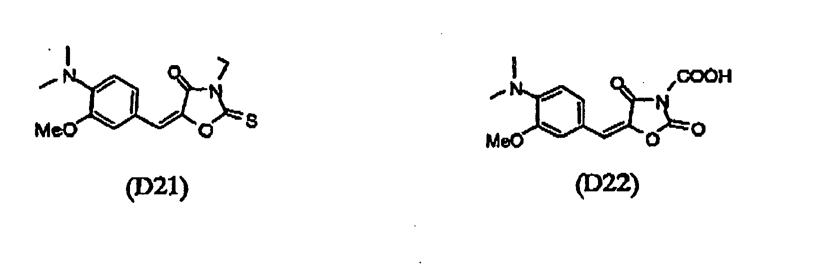

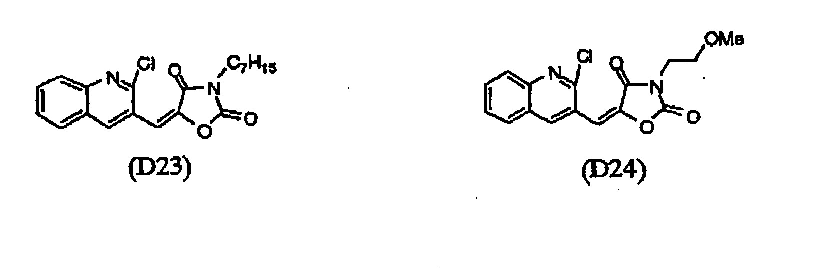

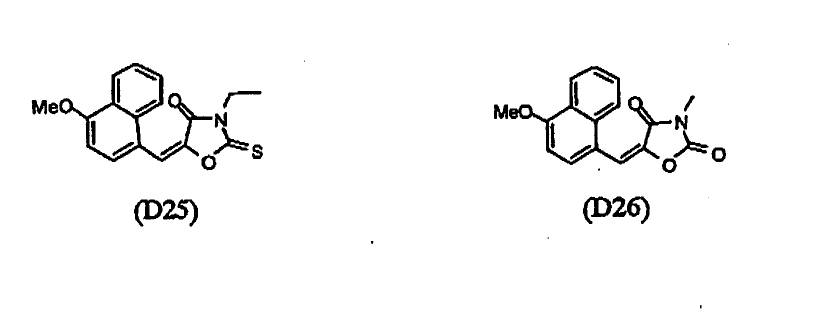

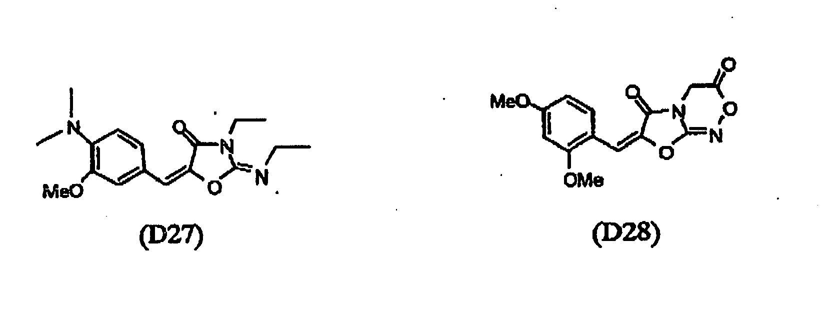

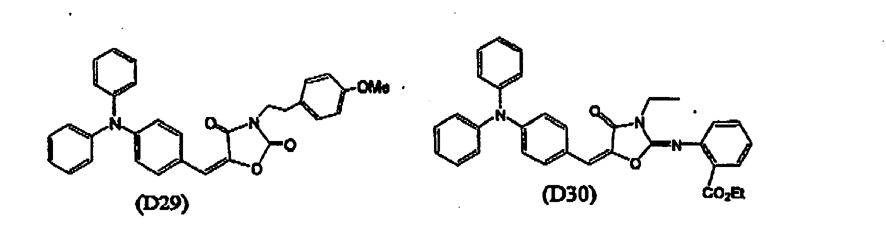

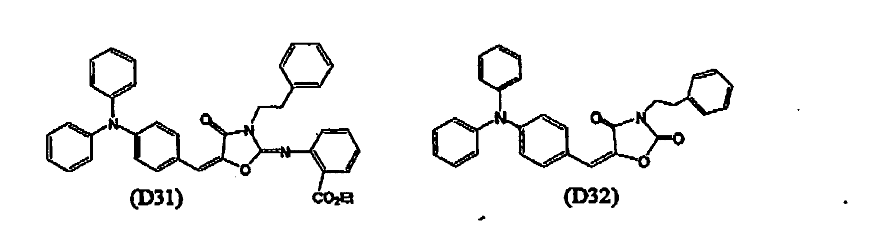

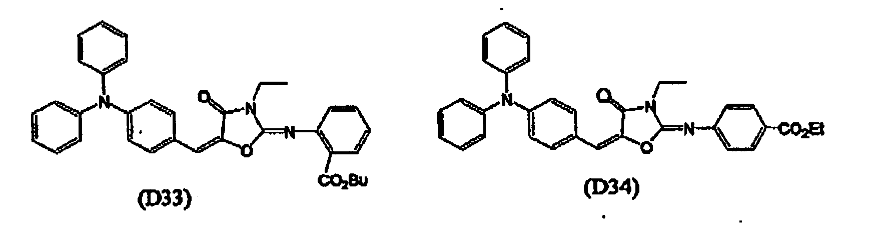

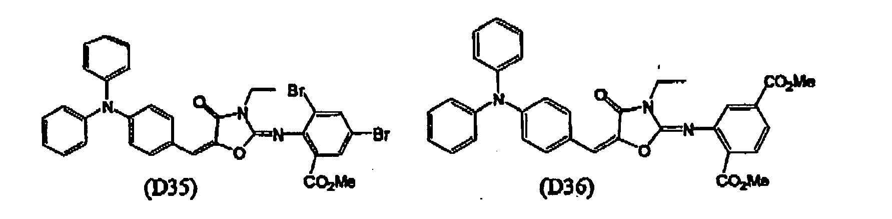

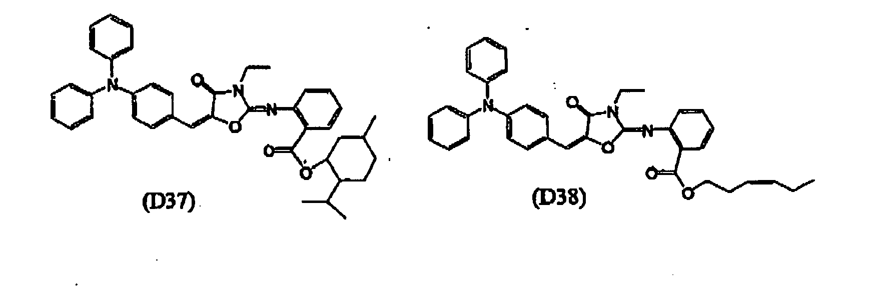

In the invention, the photosensitive layer to be formed on the support must have an absorbance (Abs) of an emitting wavelength of laser for exposure of not more than 0.4. When the subject absorbance exceeds 0.4, the light absorption distribution to the film thickness direction of the photosensitive layer inclines toward the surface of the photosensitive layer and uniform light absorption and polymerization to the film thickness direction do not proceed to the vicinity of the surface of the support so that a uniform hardened film is not obtained and that printing resistance and reproducibility of small dots are deteriorated. Therefore, such is not preferable. The subject absorbance is preferably in the range of from 0.05 to 0.4, more preferably in the range of from 0.1 to 0.3, and further preferably in the range of from 0.1 to 0.25. The subject absorbance can be regulated by the amount of addition of the foregoing sensitizing dye. Incidentally, since in the sensitizing dye, its absorptivity coefficient varies depending upon the structure thereof, the amount of addition of the sensitizing dye may be properly regulated depending upon the structure thereof. In general, the sensitizing dye is used in an amount ranging from 1.0 to 10.0 % by weight of the whole of components of the photosensitive layer.

### [(B) Polymerization initiator]

Next, the polymerization initiator which is contained in the photosensitive layer to be used in the invention will be described below. As the polymerization initiator which is contained in the photosensitive layer to be used in the invention, a variety of polymerization initiators which are known in patents, documents, and the like, or a combined system (photopolymerization initiation system) of two or more kinds of polymerization initiators can be properly chosen and used. Incidentally, in the invention, the polymerization initiator which is used singly and the combined system of two or more kinds of polymerization initiators are collectively referred to simply as "polymerization initiator".

For example, in the case where light in the vicinity of 400 nm is used as a light source, benzil, benzoin ether, Michler's ketone, anthraquinone, thioxanthone, acridine, phenazine, benzophenone, lophine dimer, and the like are widely used.

Furthermore, in the case where visible rays of 400 nm or more are used as a light source, a variety of photopolymerization initiators are also proposed. Examples thereof include certain kinds of photoreducible dyes, for example, Rose Bengale, eosine, and erythrosine, as described in U.S. Patent No. 2,850,445; and systems comprising a combination of a dye and a photopolymerization initiator, for example, a composite initiation system of a dye and an amine (as described in JP-B-44-20189), a combined system of a hexaaryl biimidazole, a radical generator and a dye (as described in JP-B-45-37377), a system of a hexaaryl biimidazole and a p-dialkylaminobenzylidene ketone (as described in JP-B-47-2528 and JP-A-54-155292), a system of a cyclic cis-α-dicarbonyl compound and a dye (as described in JP-A-48-84183) a system of a cyclic triazine and a merocyanine dye (as described in JP-A.-54-151024) , a system of 3-ketocourmarin and an activator (as described in JP-A-52-112681 and JP-A-58-15503) , a system of a biimidazole, a styrene derivative and a thiol (as described in JP-A-59-140203) , a system of an organic peroxide and a dye (as described in JP-A-59-1504, JP-A-59-140203, JP-A-59-189340, JP-A-62-174203, JP-B-62-1641, and U.S. Patent No. 4,766,055), a system of a dye and an active halogen compound (as described in JP-A-63-178105, JP-A-63-258903, and JP-A-2-63054), a system of a dye and a borate compound (as described in JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348, and JP-A-1-138204), and a system of a rhodanine ring-containing dye and a radical generator (as described in JP-2-179643 and JP-A-2-249050).

In addition, titanocene compounds are preferable as the polymerization initiator. As the titanocene compound, for example, known compounds as described in JP-A-59-152396 and JP-A-61-151197 can be properly chosen and used.

Specific examples thereof include dicyclopentadienyl-Ti-dihcloride, dicyclopentadienyl-Ti-bisphenyl, dicyclopentadienyl-Ti-bis-2,3,4,5,6-pentafluorophen-1-yl, dicyclopentadienyl-Ti-bis-2,3,5,6-tetrafluorophen-1-yl, dicyclopentadienyl-Ti-bis-2,4,6-trifluorophen-1-yl, dicyclopentadianyl-Ti-bis-2,6-difluorophen-1-yl, dicyclopentadienyl-Ti-bis-2,4-difluorophen-1-yl, dimethylcyclopentadienyl-Ti-bis-2,3,4,5,6-pentafluorophen-1-yl, dimethylcyclopentadienyl-Ti-bis-2,3,5,6-tetrafluorophen-1-yl, dimethyloyclopentadienyl-Ti-bis-2,4-difluorophen-1-yl, and bis (cyclopentadienyl)-bis (2,6-difluoro-3-(pyl-1-yl)phenyl) titanium.

Incidentally, the polymerization initiator is preferably used in an amount in the range of from 0.5 to 10.0 % by weight of the whole of components of the photosensitive layer. More preferably, the amount of the polymerization initiator is in the range of from 1.0 to 5.0 % by weight.

### [(C) Ethylenically unsaturated double bond-containing addition polymerizable compound]

The ethylenically unsaturated double bond-containing addition polymerizable compound which is contained in the photosensitive layer to be used in the invention can be arbitrarily chosen among compounds having at least one, and preferably two or more ethylenically unsaturated double bond groups.

For example, such a compound has a chemical morphology such as monomers and prepolymers, namely dimers, trimers and oligomers, or mixtures thereof, and copolymers thereof.

Examples of monomers and copolymers thereof include esters of an unsaturated carboxylic acids (for example, acrylic acid, methacrylic acid, itaconic acid, crotonic acid, isocrotonic acid, and maleic acid) and an aliphatic polyhydric alcohol compound and amides of an unsaturated carboxylic acid and an aliphatic polyhydric amine compound.

With respect to specific examples of the monomer of the ester between an aliphatic polyhydric alcohol compound and an unsaturated carboxylic acid, examples of acrylic esters include ethylene glycol diacrylate, triethylene glycol diacrylate, 1,3-butanediol diaCrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and polyester acrylate oligomers.

Examples of methacrylic esters include tetramethylene glycol dimethacrylate, triethylene glycol dimethacrylate, neopentyl glycol dimethacrylate, trimethylolpropane trimethacrylate, trimethylolethane trimethacrylate, ethylene glycol dimetharylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy) pheny]di - methylmethane, and bis [p-(methacryloxyethoxy)phenyl]di - methylmethane.

Examples of itaconic esters include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate.

Examples of crotonic esters include ethylene glycol dicrotonate, tetramethylene glycol dicrotonate, pentaerythritol dicrotonate, and sorbitol tetradicrotonate.

Examples of isocrotonic esters include ethylene glycol diisocrotonate, pentaerythritol diisocrotonate, and sorbitol tetraisocrotonate.

Examples of maleic esters include ethylene glycol dimaleate, triethylene glycol dimaleate, pentaerythritol dimaleate, and sorbitol tetramaleate.

In addition, mixtures of the foregoing ester monomers can be enumerated.

Furthermore, specific examples of the monomer of the amide between an aliphatic polyhydric amine compound and an unsaturated carboxylic acid include methylene bisacrylamide, methylene bismethacrylamide, 1,6-hexamethylene bisacrylamide, 1,6-hexamethylene bismethacrylamide, diethylenetriamine trisaarylamide, xylylene bisacrylamdie, and xylylene bismethacrylamide.

Furthermore, urethane acrylates as described in JP-A-51-37193; polyester acrylates as described in JP-A-48-64183, JP-B-49-43191, and JP-B-52-30490; and polyfunctional acrylates or methacrylates such as epoxy acrylates obtained by reaction between an epoxy resin and (meth)acrylic acid can be enumerated. Photocurable monomers and oligomers as introduced in *Journal of the Adhesion Society of Japan,* vol. 20, No. 7, pages 300 to 308 (1984) can also be used.

Specific examples thereof include NK OLIGO U-4HA, NK OLIGO U-4H, NK OLIGO U-6HA, NK OLIGO U-108A, NK OLIGO U-1084A, NK OLIGO U-200AX, NK OLIGO U-122A, NK OLIGO U-340A, NK OLIGO U-324A, and NK OLIGO UA-100 (all of which are manufactured by Shin-Nakamura Chemical Co., Ltd.) ; UA-306H, AI-600, UA-101T, UA-1011, UA-306T, and UA-3061 (all of which are manufactured by Kyoeisha Yushi Kogyo Co., Ltd.); and ART RESIN UN-9200A, ART RESIN UN-3320HA, ART RESIN UN-3320HB, ART RESIN UN-3320HC, ART RESIN SH-380G, ART RESIN SH-500, and ART RESIN SH-9832 (all of which are manufactured by Negami Chemical Industrial Co., Ltd.).

Incidentally, the amount of the ethylenically unsaturated double bond-containing addition polymerizable compound to be used is preferably in the range of from 5 to 90 % by weight, and more preferably in the range of from 10 to 80 % by weight of the whole of components of the photosensitive layer.

### [(D) Binder polymer]

Since it is required that the binder polymer is not only used as a film forming agent of the photosensitive layer but also dissolved in an alkaline developing solution, organic high-molecular polymers which are soluble or swelling in alkaline water are used.

As the organic high-molecular polymer, a variety of materials can be enumerated. When water development is desired, for example, a water-soluble organic high-molecular polymer is used. Examples of such an organic high-molecular polymer include addition polymers having a carboxyl group in the side chain thereof, for example, ones as described in JP-A-59-44615, JP-B-54-34327, JP-B-58-12577, JP-B-54-25957, JP-A-54-92723, JP-A-59-53836, and JP-A-59-71048, namely methacrylic acid copolymers, acrylic acid copolymers, itaconic acid copolymers, crotonic acid copolymers, maleic acid copolymers, partially esterified maleic acid copolymers, and the like; acidic cellulose derivatives having a carboxyl group in the side chain thereof; ones obtained by adding a cyclic acid anhydride to an addition polymer having a hydroxyl group; polyvinylpyrrolidone; polyethylene oxide; and alcohol-soluble polyamides and polyethers of 2,2-bis-(4-hydroxyphenyl)propane and epichlorohydrin, which are able to enhance the strength of a hardened film.

Of these, copolymers of [benzyl (meth)acrylate/ (meth) acrylic acid/optionally other addition polymerizable vinyl monomer] and copolymers of [allyl (meth)-acrylate/(meth)acrylic acid/optionally other addition polymerizable vinyl monomer] are especially preferable.

In addition, polyurethane resins as described in JP-B-7-120040, JP-B-7-120041, JP-B-7-120042, JP-B-8-12424, JP-A-63-287944, JP-A-63-287947, JP-A-1-271741, and JP-A-11-352691 can be used for the applications of the invention.

In such a high-molecular polymer, by introducing a radical reactive group into the side chain thereof, it is possible to enhance the strength of a hardened film. Examples of a functional group which can undergo addition polymerization reaction include an ethylenically unsaturated bond group, an amino group, and an epoxy group. Furthermore, examples of a functional group which can become a radical upon irradiation with light include a mercapto group, a thiol group, a halogen atom, a triazine structure, and an onium salt structure; and examples of a polar group include a carboxyl group and an imido group. Though as the foregoing functional group which can undergo addition polymerization reaction, ethylenically unsaturated bond groups such as an acryl group, a methacryl group, an allyl group, and a styryl group are especially preferable, a functional group selected from an amino group, a hydroxyl group, a phosphonic acid group, a phosphoric acid group, a carbamoyl group, an isocyanate group, an ureido group, an ureylene group, a sulfonic acid group, and an ammonio group can also be used.

As the binder polymer which is suitable in the invention, ones having at least structural units represented by the following formulae (1) to (3) are desirable.

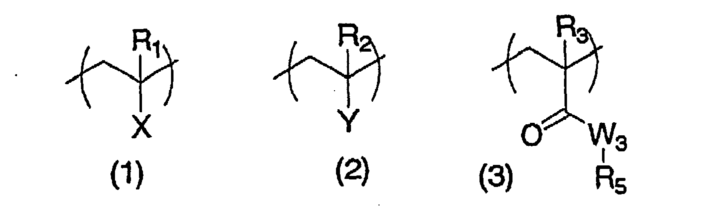

In the foregoing formulae R₁, R₂, and R₃ each independently represents a hydrogen atom or an alkyl group having from 1 to 6 carbon atoms; X represents a functional group selected from -COOH, -CO-W₁-L₁-COOH, and -SO₃H; W₁ represents an oxygen atom, a sulfur atom, or an -NH- group; L₁ represents a divalent organic group; Y represents a -CO-O-CH₂-CH=CH₂ group or a -CO-W₂-L₂-O-CO-CR₄=CH₂ group; W₂ represents an oxygen atom, a sulfur atom, or an -NH- group; L₂ represents a divalent organic group; R₄ represents a hydrogen atom or an alkyl group having from 1 to 6 carbon atoms; W₃ represents an oxygen atom, a sulfur atom, or an -NH- group; and R₅ represents an alkyl group having from 1 to 18 carbon atoms, an alkyl group having an alicyclic structure having from 5 to 20 carbon atoms, or a group having an aromatic ring having from 6 to 20 carbon atoms.

Specific examples of each of the structural units represented by the foregoing formulae (1) to (3) will be given below, but it should not be construed that the invention is limited to these structures.

Specific examples of the formula (1) include the following structural units.

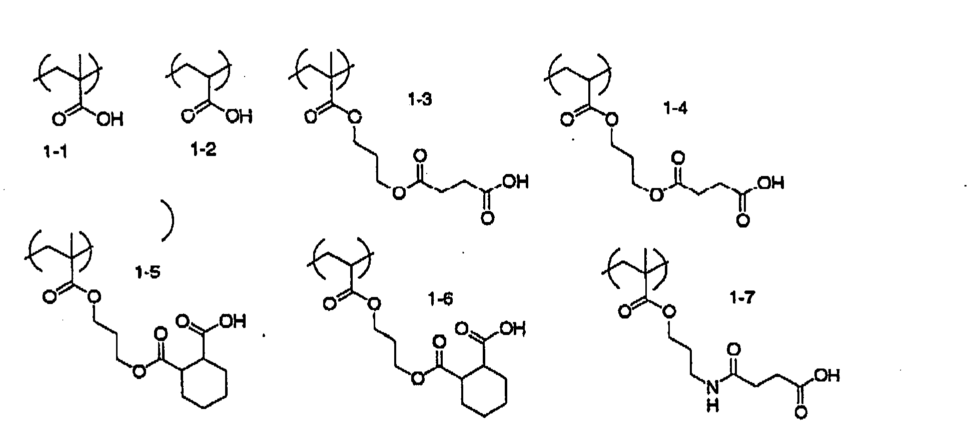

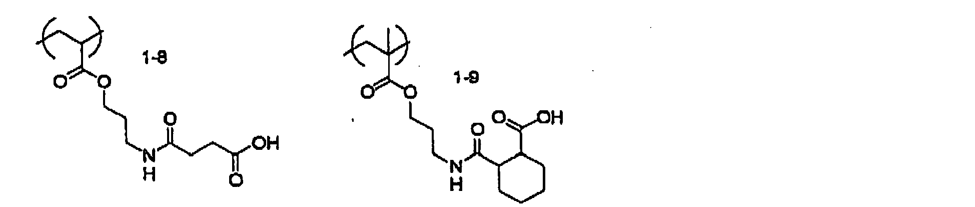

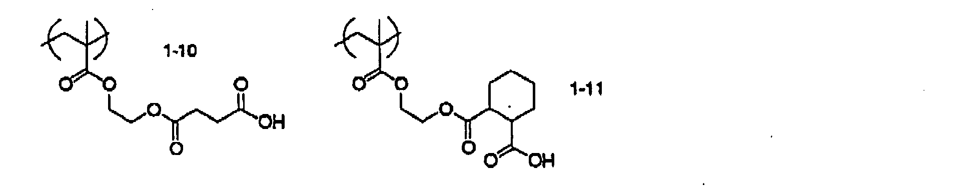

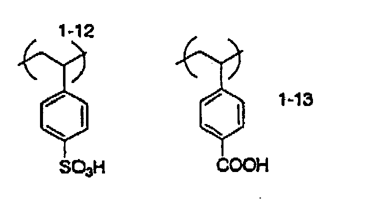

Specific examples of the formula (2) include the following structural units.

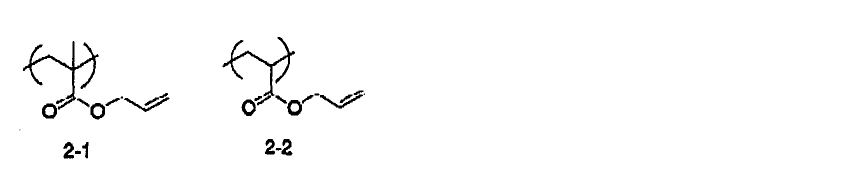

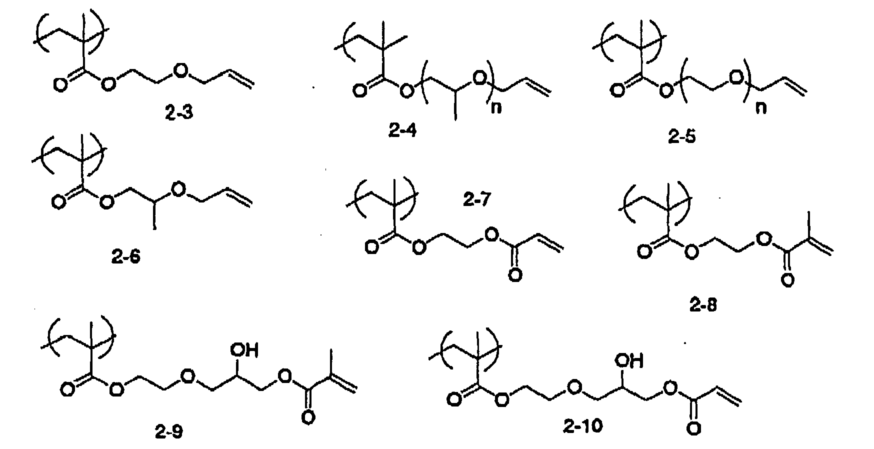

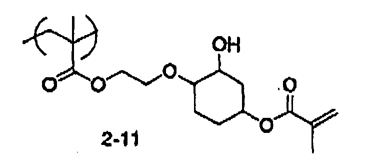

Specific examples of a monomer which can form the structural unit of the formula (3) include alkyl or aryl (meth)acrylates such as methyl (meth)acrylate, ethyl (meth)-acrylate, isobutyl (meth)acrylate, n-butyl (meth) acrylate, isopropyl (meth) acrylate, cycloheacyl (math) acrylate, n-hexyl (meth) acrylate, adamantyl (meth)acrylate, benzyl (meth)-acrylate, and phenethyl (meth)acrylate.

For the purpose of maintaining the developability of the photosensitive layer, it is preferable that the binder polymer to be used in the invention has suitable molecular weight and acid value. A binder polymer having a weight average molecular weight of from 5,000 to 300,000 and an acid value of from 0.5 to 200 is especially preferable.

Any combination regarding the proportion of the structural units represented by the formulae (1), (2) and (3) is useful so far as it satisfies the requirements of the foregoing molecular weight, acid value and amount of a double bond. Preferably, with respect to the proportion of the structural units represented by the formulae (1) , (2) and (3) , the amount of (1) is in the range of from 1 to 70 % by weight, that of (2) is in the range of from 0.5 to 98 % by weight, and that of (3) is in the range of from 0.5 to 98 % by weight in terms of a weight ratio.

Incidentally, other structural units than those of the foregoing formulae (1) to (3) may further be added within the range where the requirements of the foregoing molecular weight, acid value and amount of a double bond are satisfied.

Though such a binder polymer can be contained in an arbitrary amount in the photosensitive layer, the amount of the binder polymer to be contained is preferably from 10 to 90 % by weight, and more preferably from 30 to 80 % by weight.

Furthermore, a proportion of the foregoing ethylenically unsaturated double bond-containing addition polymerizable compound and the binder polymer to be used is not more than 1.5, especially from 0.1 to 1.5, preferably from 0.1 to 1.0, and more preferably from 0.1 to 0.8 in terms of a weight ratio of the former to the latter.

In the invention, other binder polymers than the foregoing binder polymers can be mixed and used.

As organic high-molecular polymers, a variety of materials can be enumerated. When water development is desired, for example, a water-soluble organic high-molecular polymer is used. Examples of such an organic high-molecular polymer include addition polymers having a carboxyl group in the side chain thereof, for example, ones as described in JP-A-59-44615, JP-B-54-34327, JP-B-58-12577, JP-B-54-25957, JP-A-54-92723, JP-A-59-53836, and JP-A-59-71048, namely methacrylic acid copolymers, acrylic acid copolymers, itaconic acid copolymers, crotonic acid copolymers, maleic acid copolymers, partially esterified maleic acid copolymers, and the like; acidic cellulose derivatives having a carboxyl group in the side chain thereof; ones obtained by adding a cyclic acid anhydride to an addition polymer having a hydroxyl group; polyvinylpyrrolidone; polyethylene oxide; and alcohol-soluble polyamides and polyethers of 2,2-bis-(4-hydroxyphenyl) propane and epichlorohydrin, which are able to enhance the strength of a hardened film.

In addition, polyurethane resins as described in JP-B-7-120040, JP-B-7-120041, JP-B-7-120042, JP-B-8-12424, JP-A-63-287944, JP-A-63-287947, JP-A-1-271741, and JP-A-11-352691 can be used for the applications of the invention.

Furthermore, in the photosensitive layer to be used in the invention, in addition to the foregoing basic components, it is desired to add a small amount of a thermal polymerization inhibitor during the production or storage of the composition (photosensitive composition) for forming a photosensitive layer for the purpose of preventing unnecessary thermal polymerization of the ethylenically unsaturated double bond-containing addition polymerizable compound from occurring. Examples of a suitable thermal polymerization inhibitor include hydroquinone, p-methoxyphenol, di-t-butyl-p-oresol, pyrogallol, t-butyl chatecol, benzoquinone, 4,4'-thiobis(3-methyl-6-t-butylphenol), 2,2'-methylenebis-(4-methyl-6-t-butylphenol), N-nitrosophenylhydroxylamine cerous salt, and N-nitrosophenylhydroxylamine aluminum salt. The amount of addition of the thermal polymerization inhibitor is preferably from about 0.01 % by weight to about 5 % by weight of the whole of components of the foregoing composition. Furthermore, if desired, for the purpose of preventing polymerization hindrance due to oxygen, a higher fatty acid derivative such as behenic acid and behenic amide may be added, thereby unevenly distributing it on the surface of the photosensitive layer during a drying step to be carried out after coating. The amount of addition of the higher fatty acid derivative is preferably from about 0.5 % by weight to about 10 % by weight of the whole of components of the photosensitive composition.

Moreover, for the purpose of coloring the photosensitive layer, a coloring agent may be added. Examples of the coloring agent include pigments (for example, phthalocyanine based pigments (for example, C.I. Pigment Blue 15:3, C.I. Pigment Blue 15:4, and C.I. Pigment Blue 15:6), azo based pigments, carbon black, and titanium oxide) and dyes (for example, Ethyl Violet, Crystal Violet, azo dyes, anthraquinone based dyes, and cyanine based dyes). The amount of addition of the dye or pigment is preferably from about 0.5% by weight to about 5 % by weight of the whole of components of the photosensitive composition.

In addition, for the purpose of improving physical properties of a hardened film, additives such as inorganic fillers and plasticizers (for example, dioctyl phthalate, dimethyl phthalate, and tricresyl phosphate) may be added. The amount of addition of such an additive is preferably not more than 10 % by weight of the whole of components of the photosensitive composition.

Furthermore, for the purpose of enhancing the quality of the coated surface, it is possible to add a surfactant in the composition for forming the photosensitive layer. As a suitable surfactant, for example, fluorine based nonionic surfactants can be enumerated.

In the invention, the photosensitive composition is coated on the foregoing support which has been optionally subjected to every kind of surface treatment. In coating the photosensitive composition on the support, it is dissolved in every kind of an organic solvent and then provided for use. Examples of the solvent which can be used herein include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxyethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, and ethyl lactate. These solvents can be used singly or in admixture. Incidentally, a concentration of solids in the coating solution is suitably from 2 to 50 % by weight.

The amount of coating of the photosensitive layer which is used in the invention is suitably in the range of from about 0.5 g/m² to 3.0 *g*/*m*^{*2*}*,* more preferably from 9.7 g/m² to 2.5 g/m², and further preferably from 0.8 g/m² to 2.0 g/m² in terms of a weight after coating and drying.

Furthermore, an oxygen-blocking protective layer (overcoat layer) is usually provided on the foregoing photosensitive layer for the purpose of preventing a polymerization inhibiting action of oxygen.

Moreover, in the invention, the weight of coating of the protective layer is preferably in the range of from 0.7 to 3.0 g/m² .

Examples of a water-soluble vinyl polymer which is contained in the oxygen-blocking protective layer include polyvinyl alcohol and its partial esters, ethers and acetals, and copolymers thereof containing a substantial amount of an unsubstituted vinyl alcohol unit so as to imparting necessary water solubility. As the polyvinyl alcohol, there are enumerated polyvinyl alcohols which are hydrolyzed to an extent of from 71 to 100 % and which have a molecular weight in the range of from 300 to 2,400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8, all of which are manufactured by Kuraray Co., Ltd. Examples of the foregoing copolymer include polyvinyl acetate chloroacetate or propionate, polyvinyl formal and polyvinyl acetal, each of which is hydrolyzed to an extent of from 88 to 100 %, and copolymers thereof. As other useful polymers, there are enumerated polyvinylpyrrolidone, gelatin, and gum arabic. These polymers may be used singly or in combination.

Though pure water is preferable as a solvent to be used in coating the oxygen-blocking protective layer in the photosensitive lithographic printing plate in the invention, an alcohol (for example, methanol and ethanol) or a ketone (for example, acetone and methyl ethyl ketone) may be mixed with pure water. A concentration of solids in the coating solution is suitably from 1 to 20 % by weight. In the foregoing oxygen-blocking protective layer in the invention, known additives such as a surfactant for further enhancing coating properties and a water-soluble plasticizer for improving physical properties of the film may be added. Examples of the water-soluble plasticizer include propionamide, cyclohexanediol, glycerin, and sorbitol. Furthermore, a water-soluble (meth) acrylate based polymer or the like may be added. The amount of coating thereof is suitably in the range of from about 0.1 g/m² to about 15 g/m² in terms of a weight after drying. It is more preferably from about 1.0 g/m² to about 5.0 g/m².

### [Plate-making process]

Next, the plate-making process of the photosensitive lithographic printing plate of the invention will be described below in detail. With respect to the exposure method of the foregoing photosensitive lithographic printing plate, an AlGaInN semidonductor laser (commercially available InGaN based semiconductor lasers: 5 to 30 mW) is suitable as a light source in view of wavelength characteristics and costs.

Furthermore, with respect to the exposure mechanism, any of an internal drum system, an external drum system, a flat bed system, and so on may be employed. Moreover, by using a highly water-soluble material as the photosensitive layer component of the photosensitive lithographic printing plate of the invention, it is possible to make the material soluble in neutral water or weakly alkaline water. There is also employable a system in which after mounting a photosensitive lithographic printing plate having such a construction on a printing machine, exposure and development are carried out on the machine. After the image exposure, if desired, the entire surface may be heated during a period of from exposure to development. By such heating, there is brought such an advantage that the image formation reaction in the photosensitive layer is accelerated, thereby enhancing the sensitivity or printing resistance and stabilizing the sensitivity. In addition, for the purpose of enhancing the image strength and printing resistance, it is also effective to subject, the image after development to entire post-heating or entire exposure. Usually, it is preferable that heating before the development is carried out under a mild condition of not higher than 150 °C. For heating after the development, a very strong condition is applied. Usually, the heating after the development is carried out at a temperature in the range of from 200 to 500 °C.

### (Developing solution)

The developing solution which is used in the foregoing plate-making process of the lithographic printing plate is not particularly limited. For example, a developing solution containing an inorganic alkaline salt and a nonionic surfactant and having a pH of not more than 13 is suitably used. The pH of the developing solution is more preferably from 12.5 to 10.0.

The inorganic alkaline salt can be properly used. Examples thereof include inorganic alkaline agents such as sodium hydroxide, potassium hydroxide, ammonium hydroxide, lithium hydroxide, sodium silicate, potassium silicate, ammonium silicate, lithium silicate, sodium triphosphate, potassium triphosphate, ammonium triphosphate, sodium carbonate, potassium carbonate, ammonium carbonate, sodium hydrogencarbonate, potassium hydrogencarbonate, ammonium hydrogencarbonate, sodium borate, potassium borate, and ammonium borate. These inorganic alkaline agents may be used singly or in combination of two or more kinds thereof.

In the case where a silicate is used, it is possible to easily regulate developability by regulating a mixing ratio and concentration of silicon oxide SiO₂ as a component of the silicate and an alkaline oxide M₂O (wherein M represents an alkali metal or an ammonium group). Among the foregoing alkaline aqueous solutions, ones having a mixing ratio of the foregoing silicon oxide SiO₂and the alkaline oxide M₂O (a molar ratio of SiO₂/M₂O) of from 0.5 to 3.0 are preferable, and ones having the subject mixing ratio of from 1.0 to 2.0 are more preferable. When the SiO₂/M₂O ratio is less than 0.5, the concentration of the silicate is preferably from 1 to 10 % by weight, more preferably from 3 to 8 % by weight, and most preferably from 4 to 7 % by weight based on the weight of the alkaline aqueous solution. When this concentration is 1% by weight or more, the developability and treatment ability are not lowered; and when it is not more than 10 % by weight, precipitation or crystallization hardly occurs, and gelation hardly occurs during neutralization at the time of discharging a waste liquid so that the treatment of waste liquid is not impaired.

Furthermore, for the purposes of finely adjusting the alkaline concentration and assisting the solubility of the photosensitive layer, an organic alkaline agent may be auxiliarily used jointly. Examples of the organic alkaline agent which can be used include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. These alkaline agents are used singly or in combination of two or more kinds thereof.

The surfactant can be properly used. Examples thereof include nonionic surfactants such as polyoxyalkylene ether group-containing nonionic surfactants, polyoxyethylene alkyl esters (for example, polyoxyethylene stearate), sorbitan alkyl esters (for example, sorbitan monolaurate, sorbitan monostearate, sorbitan distearate, sorbitan monooleate, sorbitan sesquioleate, and sorbitan trioleate), and monoglyceride alkyl esters (for example, glycerol monostearate and glycerol monooleate) ; anionic surfactants such as alkylbenzenesulfonic acid salts (for example, sodium dodecylbenzenesulfonate), alkylnaphthalenesulfonic acid salts (for example, sodium butylnaphthalenesulfonate, sodium pentylnaphthalenesulfonate, sodium hexylnaphthalenesulfonate, and sodium octylnaphthalenesulfonate), alkylsulfuric acid salts (for example, sodium laurylsulfate) , alkylsulfonic acid salts (for example, sodium dodecylsulfonate), and sulfosuccinic acid ester salts (for example, sodium dilaurylsulfosuccinate) ; and ampholytic surfactants such as alkyl betaines (for example, lauryl betaine and stearyl betaine) and amino acids. Of these, polyoxyalkylene ether group-containing nonionic surfactants are especially preferable.

As the polyoxyalkylene ether group-containing nonionic surfactant, ones having a structure represented by the following formula (I) are suitably used.

R₄₀-O- (R₄₁-O)ₚH (I)

In the foregoing formula (I) , R₄₀ represents an optionally substituted alkyl group having from 3 to 15 carbon atoms, an optionally substituted aromatic hydrocarbon group having from 6 to 15 carbon atoms, or an optionally substituted heteroaromatic ring group having from 4 to 15 carbon atoms (incidentally, examples of the substituent include an alkyl group having from 1 to 20 carbon atoms, a halogen atom (for example, Br, Cl, and I), an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms, and an acyl group having from 2 to 15 carbon atoms); R₄₁ represents an optionally substituted alkylene group having from 1 to 100 carbon atoms (incidentally, examples of the substituent include an alkyl group having from 1 to 20 carbon atoms and an aromatic hydrocarbon group having from 6 to 15 carbon atoms); and p represents an integer of from 1 to 100.

In the definition of the foregoing formula (I), specific examples of the "aromatic hydrocarbon group" include a phenyl group, a tolyl group, a naphthyl group, an anthryl group, a biphenyl group, and a phenanthryl group; and specific examples of the "heteroaromatic ring group" include a furyl group, a thienyl group, an oxazolyl group, an imidazolyl group, a pyranyl group, a pyridinyl group, an acridinyl group, a benzofuranyl group, a benzothienyl group, a benzopyranyl group, a benzoxazolyl group, and a benzimidazolyl group.

Furthermore, the (R₄₁-0)ₚ moiety of the formula (I) may be a combination of two or three kinds of groups so far as it falls within the foregoing range. Specifically, there are enumerated random or block-like forms of a combination, for example, a combination of an ethyleneoxy group and a propyleneoxy group, a combination of an ethyleneoxy group and an isopxopyloxy group, a combination of an ethyleneoxy group and a butyleneoxy group, and a combination of an ethyleneoxy group and an isobutylene group. In the invention, the polyoxyalkylene ether group-containing surfactant is used singly or in a composite system. It is effective to add the polyoxyalkylene ether group-containing surfactant in an amount of from 1 to 30 % by weight, and preferably from 2 to 20 % by weight in the developing solution in view of developability and printing resistance of a printing plate.

Furthermore, examples of the polyoxyalkylene ether group-containing nonionic surface represented by the foregoing formula (I) include polyoxyethylene alkyl ethers (for example, polyoxyethylene lauryl ether, polyoxyethylene cetyl ether, and polyoxyethylene stearyl ether), polyoxyethylene aryl ethers (for example, polyoxyethylene phenyl ether and polyoxyethylene naphthyl ether), and polyoxyethylene alkylaryl ethers (for example, polyoxyethylene methylphenyl ether, polyoxyethylene octylphenyl ether, and polyoxyethylene nonylphenyl ether).

Such a surfactant can be used singly or in combination. Furthermore, the content of such a surfactant in the developing solution is suitably in the range of from 0.1 to 20 % by weight as reduced into an active ingredient.

Furthermore, it is preferable that the subject developing solution has a conductivity of from 3 to 30 mS/cm. When the conductivity is 3 mS/cm or more, elution of the photopolymerizable photosensitive layer on the surface of the aluminum support becomes surely possible so that staining is not caused during printing. When the conductivity is not more than 30 mS/cm, since the salt concentration does not become excessively high, an elution rate of the photopolymerizable photosensitive layer does not become extremely low, and a residual film is not generated in an unexposed area. The conductivity is especially preferably in the range of from 5 to 20 mS/cm.

In the invention, the development of the photosensitive lithographic printing plate is carried out at a temperature of from about 0 to 60 °C, and preferably from about 15 to 40 °C according to a conventional method by, for example, dipping the exposed photosensitive lithographic printing plate in a developing solution and rubbing it with a brush or other means.

In addition, in the case where the development treatment is carried out by using an automatic processor, since the developing solution fatigues corresponding to the amount of treatment, a treatment ability may be recovered by using a replenisher or fresh developing solution.

The thus developed photosensitive lithographic printing plate is subjected to post treatments with washing water, a rinse liquid containing a surfactant, etc., and a desensitizing liquid containing gum arabic, a starch derivative, etc. as described in JP-A-54-8002, JP-A-55-115045, JP-A-59-58431, and the like. In the invention, for the post treatments of the photosensitive lithographic printing plate, a combination of a variety of these treatments can be employed.

In the printing plate as obtained by the foregoing treatments, its printing resistance can be enhanced by post exposure treatment or thermal treatment such as burning as described in JP-A-2000-89478.

The lithographic printing plate as obtained by these treatments is set in an offset printing machine and provided for printing of a number of sheets.

### EXAMPLES

The invention will be hereunder described in detail with reference to the following Examples and Comparative Example, but it should not be construed that the invention is limited thereto.

### Examples 1 and 2

### [Support Example 1]

### (Support 1: Anodically oxidized aluminum support)

The surface of an aluminum plate (material quality: 1S) having a thickness of 0.30 mm was subjected to graining by using a No. 8 nylon brush and an aqueous suspension of 800-mesh pamiston and then thoroughly washed with water. The resulting aluminum plate was dipped in and etched with 10 % by weight sodium hydroxide at 70 °C for 60 seconds, washed with running water, neutralized and washed with 20 % by weight HNO₃, and then washed with water. The aluminum plate was subjected to electrolytic roughing treatment in a quantity of electricity at the time of anode of 300 coulombs/dm² in a 1 % by weight nitric acid aqueous solution using an alternating waveform current of sine wave under a condition at a VA of 12.7 V. A surface roughness thereof was measured and found to be 0.45 µm (in terms of an Ra expression) . Subsequently, the resulting aluminum plate was dipped in a 30 % H₂SO₄ aqueous solution, subjected to desmutting at 55 °C for 2 minutes, and then subjected to anodic oxidation in a 20 % H₂SO₄ aqueous solution at a current density of 5 A/dm² for 50 seconds while disposing an anode on the grained surface. As a result, an anodically oxidized film had a thickness of 2.6 g/m². This support was designated as "support 1".

### (Support 2)

The following polymer (P1) solution was coated in the amount of coating after drying of 2 mg/m² on the foregoing support (1) by using a bar coater, followed by drying at 80 °C for 20 seconds.

### [Undercoating liquid]

| | |
|---|---|
| Polymer (PI): | 0.3 g |
| Pure water: | 60.0 g |
| Methanol: | 939.7 g |

### Structural formula of polymer (P1)

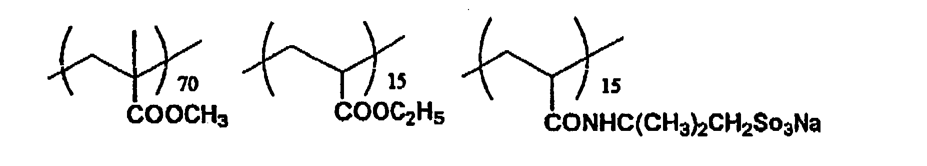

### [Photosensitive compositions P-1 to P-3]

A photosensitive composition (1) having the following composition was coated on this support (2) by using a bar coater, followed by drying at 100°C for one minute. The weight of the photosensitive composition after drying was 1.1 g/m².

| | |
|---|---|
| Ethylenically unsaturated bond-containing compound (A-1): | 1.7 parts by weight |
| High-molecular binder (B-1): | 1.7 parts by weight |
| Sensitizing dye: | Parts by weight as des cribed in Table 1 |
| Polymerization initiator (C-1) : | 0.14 parts by weight |
| ε-Phthalocyanine (F-1) dispersion: | 1.7 parts by weight |
| Sensitizing assistant (G-1): | 0.5 parts by weight |
| Fluorine based nonionic surfactant MEGAFAC F-78OF (manufactured by Dainippon Ink and Chemicals, Incorporated) | 0.03 parts by weight |
| Methyl ethyl ketone: | 27.0 parts by weight |
| Propylene glycol monomethyl ether: | 26.7 parts by weight |

Incidentally, the ethylenically unsaturated bond-containing compound (A-1), high-molecular binder (B-1), photopolymerization initiator (C-1), ε-phthalocyanine (F-1) and sensitizing assistant (G-1) as used for the preparation of the photopolymerizable photosensitive compositions of the present Examples and the following Comparative Example were compounds having the following chemical formulae, respectively. As the sensitizing dye, D10 or D30 as enumerated in the foregoing specific examples was used.

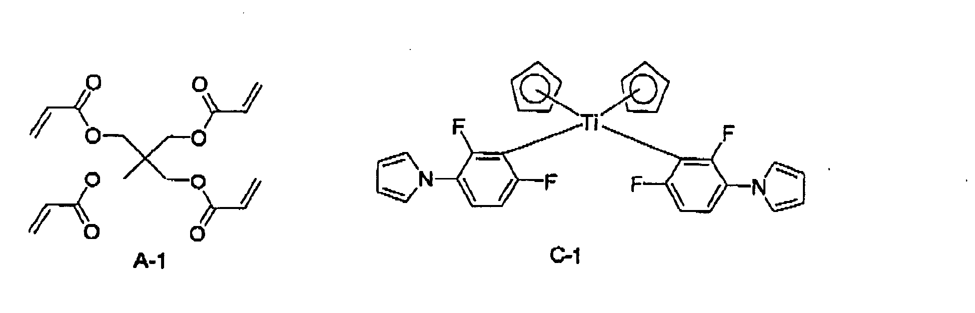

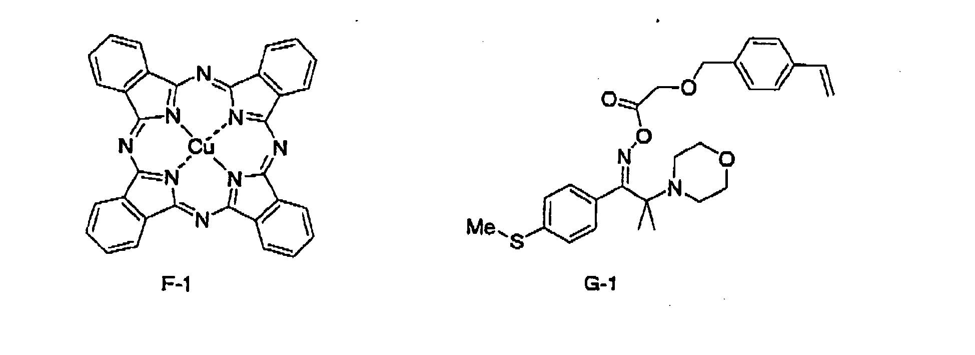

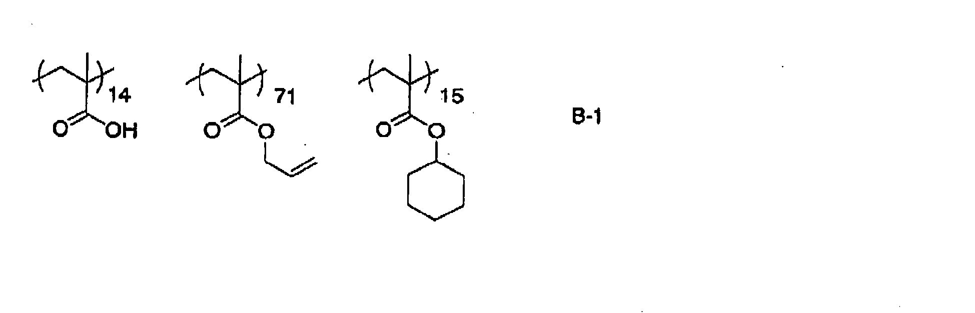

The following aqueous solution for protective layer was coated in the amount of coating after drying of 2.5 g/m² on this photosensitive layer by using a bar coater, followed by drying at 120 °C for one minute. There were thus obtained photosensitive lithographic printing plates 1 to 2.

| (Aqueous solution for protective layer) | |
|---|---|
| Polyvinyl alcohol (degree of hydrolysis: 98 % by mole, degree of polymerization: 500) : | 5.0 parts by weight |
| EMALEX 710 (nonionic surfactant as manufactured by Nippon Nyukazai Co., Ltd.) : | 0.09 parts by weight |
| Pure water: | 94.91 parts by weight |

### (Measurement of absorbance (Abs) of photosensitive layer)

Each of the foregoing polymerizable photosensitive compositions P-1 to P-2 was coated on a glass support such that the amount of coating after drying was the same as in the photosensitive layer of the photosensitive lithographic printing plate, and its transmitted UV spectrum was measured by using a spectrophotometer (U3000 as manufactured by Hitachi, Ltd.) as a measurement analyzer, thereby measuring an absorbance at 405 nm which is an emitting wavelength of a laser to be used herein. The results obtained are shown in Table 1.

### (Evaluation of unevenness in flat tint)

Each of the foregoing photosensitive lithographic printing plate precursors was mounted on a violet semiconductor laser setter VX9600 as manufactured by FUJIFILM Electronic Imaging Ltd. (InGaN based semiconductor laser, 405 nm ± 10 nm, emission/output: 30 mW) and subjected to image drawing with a flat tint of 35 % at an exposure amount of 90 µJ/cm² and at a resolution of 2,438 dpi by using an FM screen TAFFETA 20 as manufactured by Fuji Photo Film Co., Ltd. The plate after the exposure was automatically sent to an automatic processor LP1250 PLX (equipped with a brush) as connected thereto, thermally treated at 100 °C for 10 seconds, and after removing the PVA protective layer by water washing, developed at 28 °C for 20 seconds. As a developing solution, one obtained by diluting a developing solution DV-2 as manufactured by Fuji Photo Film Co., Ltd. with water at a dilution of 5 times. The developed plate was water washed in a rinse bath and then sent to a gumming bath. As the gumming bath, one obtained by diluting a gum liquid EP-2W as manufactured by Fuji Photo Film Co., Ltd. with water at a dilution of 2 times. The gummed plate was dried by hot air and then discharged to obtain a lithographic printing plate having been subjected to image drawing with a flat tint. A rate of area of the flat tint of the resulting lithographic printing plate was measured by using CC-dot, thereby measuring a difference of area (δdot) between the maximum and the minimum. The results obtained are shown in Table 1.

### Comparative Example 1

A photosensitive composition P-3 was prepared in the same manner as in the Examples, except for changing the amount of addition of the sensitizing dye in the foregoing Examples to one as described in Table 1. Using a photopolymerizable photosensitive lithographic printing plate having a photosensitive layer of this photosensitive composition, a line width and a δdot were measured in the same manner as in the Examples. The results obtained are shown in Table 1.

**Table 1**

| | Sensitizing dye | Photosensitive layer | Amount of addition of sensitizing dye | Absorbance of photosensitive layer (at 405 nm) | δdot |
|---|---|---|---|---|---|
| Example 1 | D10 | P-1 | 0.17 partis by weight | 0.3 | 2.5 % |
| Example 2 | D30 | P-2 | 0.17 parts by weight | 0.3 | 3.0 % |
| Comparative Example 1 | D30 | P-3 | 0.20 parts by weight | 0.5 | 6.0 % |

It is noted from Table 1 that the lithographic printing plates as obtained in the Examples are satisfactory with respect to uniformity of unevenness in flat tint because the absorbance of the photosensitive layer is adequately set up.

This application is based on Japanese Patent application JP 2004-248621, filed August 27, 2004, the entire content of which is hereby incorporated by reference, the same as if set forth at length.

## Claims

1. A photosensitive lithographic printing plate to be exposed by laser, which comprises a hydrophilic support and at least one polymerizable photosensitive layer, wherein the photosensitive layer has an absorbance of an emitting wavelength of the laser for exposure of not more than 0.4.

2. The photosensitive lithographic printing plate according to claim 1, wherein the photosensitive layer has an absorbance of an emitting wavelength of the laser for exposure of from 0.05 to 0.4.

3. The photosensitive lithographic printing plate according to claim 1, wherein the photosensitive layer has an absorbance of an emitting wavelength of the laser for exposure of from 0.1 to 0.3.

4. The photosensitive lithographic printing plate according to claim 1, wherein an amount of coating of the photosensitive layer is from 0.5 g/m² to 3.0 g/m².

5. The photosensitive lithographic printing plate according to claim 1, wherein an amount of coating of the photosensitive layer is from 0.7 g/m² to 2.5 g/m².

6. The photosensitive lithographic printing plate according to claim 1, wherein the photosensitive layer contains components of (A) a sensitizing dye having an absorption maximum in a wavelength region of from 360 nm to 450 nm, (B) a polymerization initiator, (C) an addition polymerizable compound having at least one ethylenically unsaturated double bond, and (D) a binder polymer, in which a weight ratio of the component (C) to the component (D) is not more than 1.5.

7. The photosensitive lithographic printing plate according to claim 1, wherein a weight ratio of the component (C) to the component (D) is from 0.1 to 1.5.

8. The photosensitive lithographic printing plate according to claim 1, wherein a weight ratio of the component (C) to the component (D) is from 0.1 to 1.0.

9. The photosensitive lithographic printing plate according to claim 1, wherein a weight ratio of the component (C) to the component (D) is from 0.1 to 0.8.

10. The photosensitive lithographic printing plate according to claim 1, further comprising a protective layer containing a water-soluble vinyl polymer so that the hydrophilic support, the at least one polymerizable photosensitive layer and the protective layer are in this order.
